# EUROPÄISCHE PATENTSCHRIFT

(11) **EP 3 707 475 B1**
(45) Veröffentlichungstag und Bekanntmachung des Hinweises auf die Patenterteilung: **07.07.2021**
(21) Anmeldenummer: 18752728.8
(22) Anmeldetag: 03.08.2018
(51) Int. Cl.: G01D 5/14, H01H 36/00, H03K 17/97

(54) **SCHALTER MIT MAGNETANORDNUNG**
SWITCH HAVING A MAGNET ARRANGEMENT
INTERRUPTEUR DOTÉ D'UN ENSEMBLE D'AIMANTS

(30) Priorität: 09.11.2017 DE 102017219984
(43) Veröffentlichungstag der Anmeldung: 16.09.2020
(73) Patentinhaber: Griessbach GmbH, 14943 Luckenwalde (DE)
(72) Erfinder: POKRANDT, Christian, 14947 Nuthe-Urstromtal (DE)
(74) Vertreter: Pfenning, Meinig & Partner mbB
(86) Internationale Anmeldenummer: PCT/EP2018/071171
(87) Internationale Veröffentlichungsnummer: WO 2019/091611

(56) Entgegenhaltungen:
- EP-A1- 2 843 370
- WO-A1-2007/080941
- DE-A1- 2 532 981
- DE-C1- 19 701 927
- US-A1- 2015 050 013

## Beschreibung

Die vorliegende Erfindung betrifft einen Schalter mit einer Magnetanordnung. Aus dem Stand der Technik sind bereits Sensoren zum Detektieren von Magnetfeldern bekannt, die oftmals auch als Positionssensoren eingesetzt werden. Beispielsweise offenbart die Druckschrift DE 10 2012 204 634 A1 einen Magnetfeldsensor, bei dem ein Magnet in mehrere Positionen bewegt werden kann. Die DE 25 32 981 A1 offenbart einen ähnlichen Magnetfeldsensor, der als kontaktloser magnetischer Schalter verwendet wird. Nachteilig an derartigen aus dem Stand der Technik bekannten Lösungen ist jedoch, dass die Sensoren empfindlich auf Fremdmagnetfelder reagieren, die eine Funktion solcher Sensoren und somit auch deren Schalteigenschaften empfindlich beeinträchtigen können.

Der vorliegenden Erfindung liegt daher die Aufgabe zugrunde, einen Schalter zu entwickeln, der die genannten Nachteile vermeidet, mit dem also auch bei Vorliegen eines Fremdmagnetfelds ein zuverlässiges Schalten möglich ist.

Diese Aufgabe wird erfindungsgemäß gelöst durch einen Schalter nach Anspruch 1. Vorteilhafte Ausgestaltungen und Weiterbildungen sind in den abhängigen Ansprüchen beschrieben.

Ein Schalter weist eine Magnetanordnung mit mindestens einem ersten Magneten und einem ersten Magnetfelddetektor und einem zweiten Magnetfelddetektor auf. Der erste Magnetfelddetektor gibt ein erste elektrisches Signal aus, der zweite Magnetfelddetektor ein zweites elektrisches Signal. Sensitive Oberflächen des ersten Magnetfelddetektors und des zweiten Magnetfelddetektors sind parallel zueinander ausgerichtet. Die Magnetanordnung ist zwischen dem ersten Magnetfelddetektor und dem zweiten Magnetfelddetektor in einer Relativbewegung parallel zu den sensitiven Oberflächen bzw. in einer Ebene parallel zu den sensitiven Oberflächen bewegbar angeordnet. Ein von dem ersten Magnetfelddetektor und ein von dem zweiten Magnetfelddetektor detektierter Vektor des Magnetfelds in einer ersten Endlage der Relativbewegung und in einer zweiten Endlage der Relativbewegung weist in nur einer detektierten Komponente des Vektors des Magnetfelds ein unterschiedliches Vorzeichen auf. Außerdem ist der Schalter mit einer elektrischen oder elektronischen Auswerteeinheit versehen, die dem ersten Magnetfelddetektor und dem zweiten Magnetfelddetektor nachgeschaltet ist. Diese Auswerteeinheit ist dazu eingerichtet, eine Differenz des ersten elektrischen Signals und des zweiten elektrischen Signals zu ermitteln und bei Erreichen eines festgelegten ersten Werts der Differenz bei der Relativbewegung von der ersten Endlage in die zweite Endlage der Relativbewegung ein erste Schaltsignal und bei Erreichen eines festgelegten zweiten Werts der Differenz bei der Relativbewegung von der zweiten Endlage in die erste Endlage der Relativbewegung ein zweites Schaltsignal auszugeben.

Der Vektor des Magnetfelds ist hierbei eine mathematische Darstellung des zugrundeliegenden physikalischen Felds, wobei im angenommenen dreidimensionalen Raum drei Komponenten benötigt werden, um den entsprechenden Magnetfeldvektor hinreichend zu beschreiben. Dementsprechend messen der erste und der zweite Magnetfelddetektor an ihren Positionen jeweils einen Magnetfeldvektor und nur eine der an den beiden Detektoren ermittelten Komponenten der jeweiligen Vektoren unterscheidet sich im Vorzeichen. D. h. ausschließlich eine einzelne der Komponenten wird an einem der Magnetfelddetektoren mit einem positiven Vorzeichen gemessen und an dem anderen der Magnetfelddetektoren mit einem negativen Vorzeichen.

Das erste elektrische Signal und das zweite elektrische Signal können sich in ihrer Polarität unterscheiden, um bei Einwirkung eines Fremdfelds eine hohe Störsicherheit zu erzielen.

Der festgelegte erste Wert und der festgelegte zweite Wert der Differenz sind typischerweise gleich, um ein einheitliches Schaltverhalten zu gewährleisten, können sich zum Erzielen von Hystereseeffekten aber auch voneinander unterscheiden. In besonders bevorzugter Weise sind die beiden Werte gleich, d.h., bei einem gleichzeitigen Detektieren identischer Werte der von den Magnetfelddetektoren ausgegebenen elektrischen Signale wird, beispielsweise durch einen Komparator, der festgelegte Wert der Differenz festgestellt.

Typischerweise erfolgt die Relativbewegung innerhalb des mit dem ersten Magnetfelddetektor und mit dem zweiten Magnetfelddetektor detektierbaren Magnetfelds der Magnetanordnung. Da ein Magnetfeld physikalisch gesehen keine scharfe Grenze aufweist, soll die Relativbewegung ausschließlich in einem Raumbereich erfolgen, in dem ein von der Magnetanordnung generiertes Magnetfeld an einer beliebigen Position größer als eine untere Detektionsschwelle eines der Magnetfelddetektoren ist.

Ein Abstand zwischen dem Magneten und dem ersten Magnetfelddetektor, ein Abstand zwischen dem Magneten und dem zweiten Magnetfelddetektor und bzw. oder ein Abstand zwischen dem ersten Magnetfelddetektor und dem zweiten Magnetfelddetektor ist bzw. sind vorzugsweise kleiner als eine maximale Ausdehnung des jeweiligen Magneten. Unter einer maximalen Ausdehnung soll hierbei insbesondere eine möglichst lange Wegstrecke innerhalb eines von dem Magneten gefüllten Raumvolumens verstanden werden.

Typischerweise beträgt ein Abstand zwischen einer Oberfläche der Magnetanordnung und einer sensitiven Oberfläche des ersten Magnetfelddetektors oder ein Abstand zwischen einer Oberfläche der Magnetanordnung und einer sensitiven Oberfläche des zweiten Magnetfelddetektors maximal 1,5 mm. Bei derartig geringen Abständen wirkt ein Fremdfeld praktisch identisch auf die beiden Magnetfelddetektoren, so dass durch den beschriebenen Schalter eine höhere Widerstandsfähigkeit gegenüber Fremdfeldern und somit ein zuverlässigeres Schalten erreicht wird.

Es kann vorgesehen sein, dass die in ihrem Vorzeichen unterschiedliche Komponente, die am ersten Magnetfelddetektor detektiert wird, betragsmäßig gleich der entsprechenden Komponente ist, die am zweiten Magnetfelddetektor detektiert wird. In einer symmetrischen Anordnung kann somit in einfacher Weise eine Detektion der Komponenten erfolgen und eine erhöhte Widerstandsfähigkeit gegenüber Fremdmagnetfeldern erreicht werden. Unter dem Begriff "betragsmäßig gleich" soll hierbei auch ein Feldstärkeunterschied von bis zu 10 Prozent des größeren Werts als Differenz gegenüber dem kleineren Wert verstanden werden.

Der Schalter kann ein Sensorelement mit den nachfolgend beschriebenen Eigenschaften aufweisen. Das Sensorelement weist typischerweise die Magnetanordnung und eine Sensoranordnung auf. Die Magnetanordnung umfasst den ersten Magneten zum Bereitstellen des Magnetfelds, die Sensoranordnung zum Detektieren einer Änderung des Magnetfelds mindestens den ersten Detektor als Magnetfelddetektor und mindestens den zweiten Detektor als Magnetfelddetektor. Die Magnetanordnung und die Sensoranordnung sind mit einem räumlichen Abstand relativ zueinander beweglich. Zumindest der mindestens eine erste Detektor oder der mindestens eine zweite Detektor ist vorzugsweise außerhalb der Längsachse des ersten Magneten angeordnet und dazu ausgebildet, jeweils Anteile eines Magnetflusses des Magnetfelds zu detektieren, die in ihrer durch den jeweiligen Detektor verlaufenden Flussrichtung voneinander abweichen. Hierbei ist in der Regel die Längsachse gleich der Magnetisierungsrichtung.

Durch die bewegliche Anordnung der Magnetanordnung und der Sensoranordnung kann eine Änderung des Magnetfelds an der Sensoranordnung detektiert werden, da sich der Magnetfluss bzw. magnetische Fluss beispielsweise hinsichtlich Flussdichte räumlich ändert. Indem mindestens zwei Detektoren vorgesehen sind, die unterschiedliche Anteile des Magnetflusses detektieren, kann eine zuverlässige Detektion des von der Magnetanordnung bereitgestellten Magnetfelds erfolgen, da die detektierte Änderung in der Regel ein unterschiedliches Vorzeichen aufweist, während Fremdmagnetfelder typischerweise in einer Änderung mit gleichem Vorzeichen resultieren. Indem die Detektoren außerhalb der Längsachse angeordnet sind, ist eine Empfindlichkeit gegenüber Feldänderungen nicht nur von der Empfindlichkeit des Detektors abhängig. Unter dem Begriff "Fremdmagnetfeld" soll im Rahmen dieser Schrift insbesondere ein externes, nicht von der Magnetanordnung generiertes Magnetfeld verstanden werden. Es können auch sowohl der erste Detektor als auch der zweite Detektor außerhalb der Längsachse des ersten Magneten angeordnet sein, also keinen Schnittpunkt mit dieser Längsachse aufweisen. Insbesondere kann das Sensorelement derart ausgestaltet sein, dass stets, also bei jeder durch die Bewegung erreichbaren Position der Magnetanordnung und bzw. oder der Sensoranordnung, einer der beiden Detektoren oder beide Detektoren außerhalb der Längsachse des Magneten angeordnet sind.

Zum erweiterten Auswerten der detektierten Änderung kann die Sensoranordnung mit der elektrischen oder elektronischen Auswerteeinheit elektrisch leitend verbunden sein. Es kann auch eine Ausgabeeinheit zum optischen oder akustischen Ausgeben der detektierten Änderung vorgesehen sein, die elektrisch leitend mit der Auswerteeinheit verbunden ist.

Der erste Magnetfelddetektor und bzw. oder der zweite Magnetfelddetektor kann als ein Magnetowiderstandseffektsensor, als ein Hall-Effektsensor und bzw. oder ein Riesenmagnetowiderstandseffektsensor ausgebildet sein, um zuverlässig das Magnetfeld detektieren zu können.

Der erste Magnetfelddetektor und der zweite Magnetfelddetektor können derart angeordnet sein, dass Flusslinien des von der Magnetanordnung generierten Magnetfelds die Magnetfelddetektoren in unterschiedlichen Richtungen durchqueren. In besonders bevorzugter Weise ist eine Richtung des Magnetflusses durch den ersten Detektor gerade entgegengesetzt zu einer Richtung des Magnetflusses durch den zweiten Detektor, wobei eine Winkeldifferenz von bis zu 10° erlaubt sein soll.

Es kann auch vorgesehen sein, dass der erste Magnetfelddetektor und der zweite Magnetfelddetektor derart angeordnet sind, dass in ihrer Flussrichtung durch den jeweiligen Detektor gegenläufige Anteile des Magnetflusses detektiert werden. Dadurch, dass Anteile mit in verschiedene Richtungen weisender Flussrichtung ermittelt werden kann durch von den Detektoren bereitgestellte elektrische Signale besonders einfach auf eine von dem Magnetfeld der Magnetanordnung induzierte Magnetfeldänderung geschlossen werden.

Es kann auch vorgesehen sein, dass ein zweiter Magnet derart angeordnet ist, dass seine Längsachse mit der Längsachse des ersten Magneten übereinstimmt (sowie typischerweise mit der Magnetisierungsrichtung des ersten Magneten und des zweiten Magneten). Dies ermöglicht eine platzsparende Anordnung und gleichzeitig eine effiziente Detektion von Änderungen des Magnetfelds. Die Magnetanordnung umfasst in diesem Fall also zumindest den ersten Magneten und den zweiten Magneten.

Der erste Magnet und der zweite Magnet können hierbei derart in einem Führungselement gelagert sein, dass identische Magnetpole beider Magnete einander zugewandt sind (also Nordpol und Nordpol oder Südpol und Südpol benachbart angeordnet sind) oder voneinander verschiedene Magnetpole des ersten Magneten und des zweiten Magneten einander zugewandt sind. Durch das Führungselement wird eine Beweglichkeit der Magnete eingeschränkt, so dass nur noch eine definierte Bewegung durchgeführt werden kann. Die Anordnung der Pole erlaubt zudem eine einfache Bestimmung der Änderung des Magnetfelds nach einer Bewegung der Sensoranordnung oder der Magnetanordnung.

Typischerweise ist die Relativbewegung zwischen der ersten Endlage und der zweiten Endlage eine Linearbewegung, es kann aber auch eine Drehbewegung vorgesehen sein. Die erste Endlage und die zweite Endlage sollen hierbei Positionen der Relativbewegung bezeichnen, an denen, beispielsweise durch mechanische Mittel, eine weitere Bewegung in der zuvor eingeschlagenen Richtung unterbunden wird. Die erste Endlage und die zweite Endlage stellen somit auch Wendepunkte der Relativbewegung dar.

Der erste Magnet und der zweite Magnet können derart angeordnet sein, dass die Längsachsen parallel zueinander angeordnet sind. Vorzugsweise ist ein Nordpol des ersten Magneten hierbei einem Südpol des zweiten Magneten benachbart.

Es kann vorgesehen sein, dass die Magnetanordnung neben dem ersten Magneten und dem zweiten Magneten einen dritten Magneten aufweist, wobei der dritte Magnet mit seiner Längsachse parallel zu den Längsachsen des ersten Magneten und des zweiten Magneten angeordnet ist und ein Nordpol des dritten Magneten einem Südpol des zweiten Magneten zugewandt angeordnet ist.

Der erste Magnet und bzw. oder der zweite Magnet können als Permanentmagnet oder als Elektromagnet ausgeführt sein, wobei beide Magneten vom gleichen Typ sein können, aber auch von verschiedenen Typen sein können.

Es kann vorgesehen sein, dass der erste Magnetfelddetektor und der zweite Magnetfelddetektor mit ihren sensitiven Oberflächen fluchtend einander gegenüberliegend angeordnet sind, um einen einfachen symmetrischen Aufbau zu gewährleisten. Der erste Magnetfelddetektor und der zweite Magnetfelddetektor können mit ihren sensitiven Oberflächen auch versetzt zueinander angeordnet sein.

Der Schalter kann einen Positionssensor aufweisen. Der Positionssensor kann ein Sensorelement mit den zuvor beschriebenen Eigenschaften aufweisen. Die Magnetanordnung oder die Sensoranordnung sind hierbei typischerweise an einem mechanisch betätigbaren und als Folge der Betätigung beweglichen Betätigungselement angeordnet, so dass aus dieser Betätigung die detektierbare Änderung des Magnetfelds und entsprechend der Änderung auf eine Position des Betätigungselements geschlossen werden kann. Insbesondere können die Magnetanordnung oder der erste Magnetfelddetektor und der zweite Magnetfelddetektor an einem mechanisch betätigbaren und als Folge der Betätigung beweglichen Betätigungselement angeordnet sein.

Der Schalter bzw. der Positionssensor kann derart aufgebaut sein, dass die Magnetanordnung und die Sensoranordnung durch mindestens ein weiteres Bauteil räumlich voneinander getrennt sind. Somit kann, insbesondere bei verschmutzungsempfindlichen Bauteilen, eine der Anordnungen in einem geschlossenen Innenraum gelagert sein und gleichzeitig eine zuverlässige Detektion von Magnetfeldänderungen erfolgen.

Bei dem erfindungsgemäßen Verfahren zum Detektieren einer Änderung eines Magnetfelds wird eine Magnetanordnung mit mindestens einem ersten Magneten zum Bereitstellen des Magnetfelds und einer Sensoranordnung zum Detektieren einer Änderung des Magnetfelds mit mindestens einem ersten Detektor und mindestens einem zweiten Detektor mit einem räumlichen Abstand zueinander bewegt. Zumindest der mindestens eine erste Detektor oder der mindestens eine zweite Detektor sind außerhalb der Längsachse des ersten Magneten angeordnet. Durch den ersten Detektor und den zweiten Detektor werden jeweils Anteile eines Magnetflusses des Magnetfelds detektiert, die in ihrer Flussrichtung, in der sie durch den jeweiligen Detektor hindurchtreten, voneinander abweichen.

Das beschriebene Verfahren ist mit dem beschriebenen Schalter, dem beschriebenen Sensorelement und bzw. oder mit dem beschriebenen Positionssensor durchführbar, d. h. der beschriebene Schalter, das beschriebene Sensorelement und bzw. oder der beschriebene Positionssensor sind zum Durchführen des beschriebenen Verfahrens ausgebildet.

Das beschriebene Sensorelement und bzw. oder der beschriebene Positionssensor kann bzw. können als Schaltelement verwendet werden. Ebenso kann das beschriebene Verfahren ein Schaltverfahren sein.

Es zeigen:
- Fig. 1: eine schematische Ansicht eines Sensorelements;
- Fig. 2: eine Draufsicht auf ein Sensorelement mit redundanter Ausführung von Detektoren;
- Fig. 3: eine Figur 1 entsprechende Ansicht eines nicht zur Erfindung gehörenden Beispiels des Sensorelements mit an unterschiedlichen Seiten eines Magneten angeordneten Detektoren;
- Fig. 4: eine seitliche Ansicht eines nicht zur Erfindung gehörenden Beispiels, bei dem der Magnet gegenüber einer Reihenanordnung von Detektoren beweglich ist;
- Fig. 5: eine Figur 4 entsprechende Ansicht mit einer elektronischen Auswerteeinheit;
- Fig. 6: einen Kippschalter mit einem Sensorelement in seitlicher Ansicht;
- Fig. 7: eine schematische Ansicht einer Ausführungsform des Sensorelements mit auf einem Kreisbogen angeordneten Detektoren;
- Fig. 8: eine seitliche Ansicht eines Positionssensors, bei der der Magnet und die Detektoren durch ein Bauteil räumlich voneinander getrennt sind;
- Fig. 9: eine Draufsicht auf ein erfindungsgemäßes Sensorelement;
- Fig. 10: eine Figur 9 entsprechende Ansicht mit redundanten Detektoren;
- Fig. 11: einen Positionssensor mit durch eine Feder beweglich gelagerten Magneten;
- Fig. 12: eine seitliche Ansicht eines Positionssensors mit zwei in einem Führungselement gelagerten Magneten, die durch Polzuordnung einander abstoßend angeordnet sind;
- Fig. 13: eine Figur 12 entsprechende seitliche Ansicht mit durch äußere Krafteinwirkung zusammengefügten Magneten und daraus resultierenden Feldänderungen;
- Fig. 14: ein Betätigungselement in einer Figur 12 entsprechenden Ansicht mit durch Polanordnung aneinander haftenden Magneten;
- Fig. 15: eine Figur 14 entsprechende Ansicht des Betätigungselements mit durch äußere Krafteinwirkung getrennten Magneten und dadurch geänderten Feldverläufen,
- Fig. 16: einen zeitlichen Verlauf von elektrischen Signalen der Magnetfelddetektoren und
- Fig. 17: eine Schnittdarstellung eines Schalters.

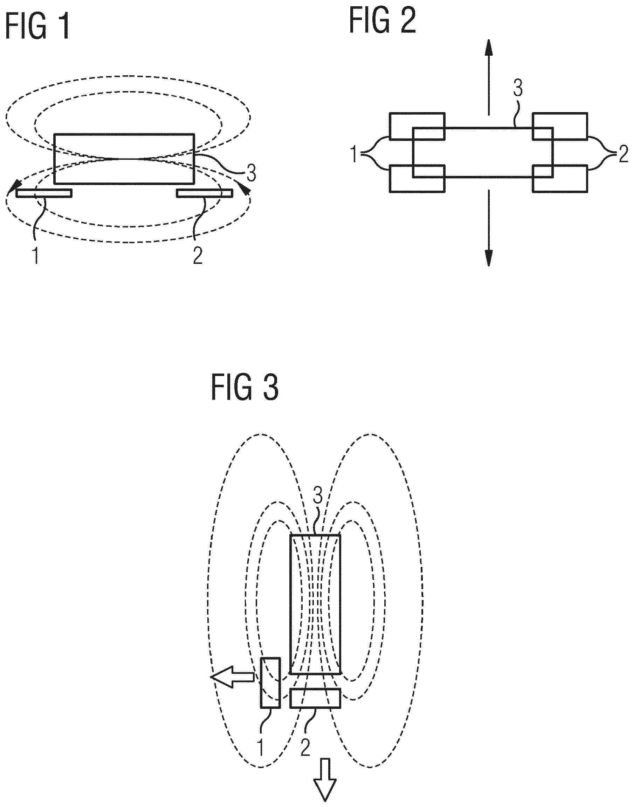

Figur 1 zeigt in einer schematischen Ansicht ein Sensorelement mit einer Magnetanordnung als Gebereinrichtung und einer Sensoranordnung als Detektierungseinrichtung. Die Magnetanordnung umfasst einen ersten Magneten 3, der im vorliegenden nicht zur Erfindung gehörenden Beispiel als stabförmiger Permanentmagnet ausgeführt ist, jedoch in weiteren nicht zur Erfindung gehörenden Beispielen auch als Elektromagnet, beispielsweise als elektrische Spule mit Ferritkern, vorliegen kann. Die Sensoranordnung weist einen ersten Detektor 1 als ersten Magnetfelddetektor und einen zweiten Detektor 2 als zweiten Magnetfelddetektor auf. Die beiden Detektoren 1 und 2 sind im dargestellten nicht zur Erfindung gehörenden Beispiel Hall-Effektsensoren, können in weiteren nicht zur Erfindung gehörenden Beispielen aber auch unterschiedliche Typen von Detektoren sein. Beispielsweise kann zumindest einer der Detektoren 1 und 2 ein Riesenmagnetowiderstandssensor sein. Die Detektoren 1, 2 sind dicht an dem Magneten 3 angeordnet, worunter ein Abstand kleiner oder gleich 3 mm, vorzugsweise kleiner als 1,5 mm, verstanden werden soll. Durch eine derartige dichte Anordnung und geringe Magnetabmessungen weisen von außen einwirkende Fremdmagnetfelder weitgehend homogene Verläufe in einem durch die beiden Detektoren 1, 2 definierten Detektionsbereich auf.

Der Magnet 3 und die Detektoren 1 und 2 sind räumlich voneinander beabstandet und in diesem Abstand relativ zueinander bewegbar, d. h. die Magnetanordnung mit dem Magneten 3 kann ortsfest angeordnet sein und die Sensoranordnung wird bewegt oder die Sensoranordnung, d. h. die Detektoren 1, 2 sind ortsfest und die Magnetanordnung wird bewegt. Auch bei der Bewegung erfolgt keine direkte, also unmittelbare Berührung. Die Bewegung selbst kann hierbei orthogonal, parallel oder in beliebiger Richtung einer durch Mittelpunkte der Detektoren 1 und 2 definierten Sensierebene erfolgen. Der Magnet 3 ist mit Feldlinien seines Magnetfelds bzw. seines Magnetflusses in Figur 1 dargestellt. Um unterschiedlich gerichtete Anteile des Magnetflusses detektieren zu können (was in Figur 1 durch die Pfeile an den Feldlinien verdeutlicht wird), sind der erste Detektor 1 und der zweite Detektor 2 in dem dargestellten nicht zur Erfindung gehörenden Beispiel außerhalb der Längsachse des Magneten 3, also außerhalb der Achse der größten räumlichen Ausdehnung des Magneten 3 bzw. der Achse, die parallel zur Magnetisierungsrichtung verläuft, angeordnet. Zudem wurde die Anordnung und die elektrische Verschaltung derart gewählt, dass Anteile des Magnetflusses detektiert werden, die in ihrer Flussrichtung durch den jeweiligen Detektor 1, 2 voneinander abweichen. Insbesondere ist in Figur 1 die Anordnung derart gewählt, dass gegenläufige Anteile, also Anteile deren Flussrichtung um 180° verschieden ist, detektiert werden.

Figur 2 zeigt in einer Draufsicht ein nicht zur Erfindung gehörendes Beispiel, bei dem die Detektoren 1 und 2 zur Erhöhung der Zuverlässigkeit redundant ausgeführt sind. Wiederkehrende Merkmale sind in dieser Figur wie auch in den folgenden Figuren mit identischen Bezugszeichen versehen. An einer Seite des Magneten 3 sind somit die Detektoren 1, an einer gegenüberliegenden Seite die Detektoren 2 angeordnet. Der Magnet 3 ist wie in Figur 2 gezeigt in einer lateralen Bewegung zu den Detektoren 1, 2 verschiebbar. Die Detektoranordnung weist in dem dargestellten nicht zur Erfindung gehörenden Beispiel eine unabhängig voneinander ausgeführte Konfiguration der Detektoren 1, 2 auf.

In Figur 3 ist in einer Figur 1 entsprechenden Ansicht eine nicht zur Erfindung gehörende Ausführungsform wiedergegeben, bei der der Detektor 1 außerhalb der Längsachse des Magneten 3 angeordnet ist, der zweite Detektor 2 jedoch fluchtend zu dem Magneten 3 in der Längsachse liegt. Hierdurch kann besonders effizient eine unterschiedliche Flussdichte detektiert werden, die sich entsprechend des Abstands des Magneten 3 zu den Detektoren 1, 2 ändert.

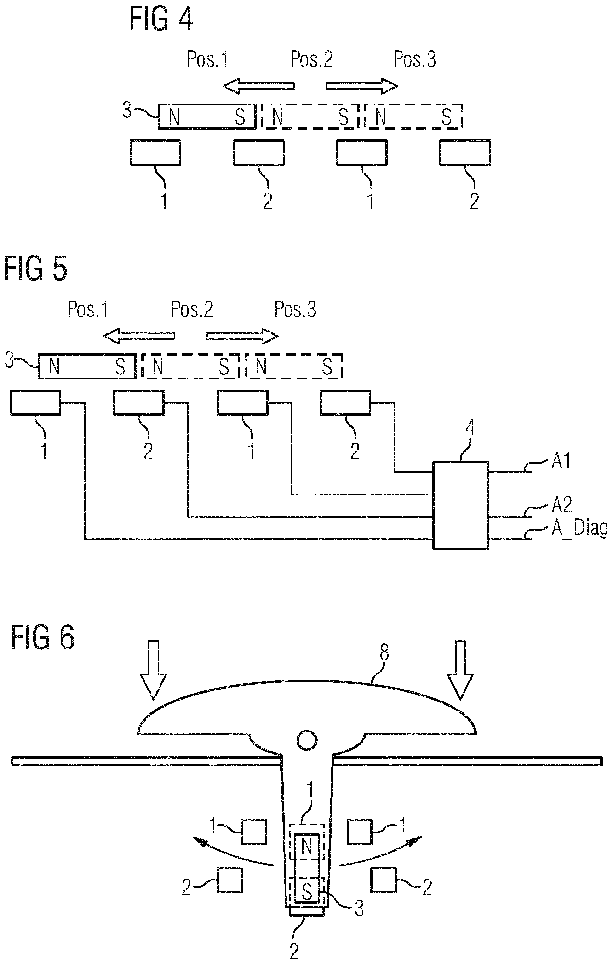

Figur 4 zeigt in einer seitlichen Ansicht einen Positionssensor, der das beschriebene Sensorelement aufweist. Eine Vielzahl von Detektoren 1, 2 sind fluchtend und parallel zueinander angeordnet, während oberhalb dieser Detektoren 1, 2 der Magnet 3 mit eingezeichneter Polorientierung in verschiedene Positionen bewegt wird. Somit ändert sich das detektierte Signal der Detektoren 1, 2 je nach Position des Magneten 3.

Diese Anordnung ist in Figur 5 um eine elektronische Auswerteeinheit 4 ergänzt gezeigt, in der die elektrischen Signale der Detektoren 1 und 2 verarbeitet und ausgewertet werden. Dies kann beispielsweise durch ein Differenzierglied erfolgen. Ein Ausgangssignal der Auswerteeinheit 4 kann dann auf einer Ausgabeeinheit, beispielsweise einem Monitor oder einem Display, wiedergegeben werden. Die Auswerteeinheit 4 kann dazu eingerichtet sein, bei Überschreiten eines vorgegebenen Schwellwerts der von den Detektoren 1 und 2 kommenden Eingangssignale ein Ausgangssignal zu ändern, das bei Unterschreiten dieses Schwellwerts wieder auf einen ursprünglichen Wert zurückgesetzt wird. Der Schwellwert kann hierbei in Abhängigkeit beider Detektorsignale oder nur eines Detektorsignals definiert sein.

Zudem kann auch eine Hysteresefunktionalität in der Auswerteeinheit 4 realisiert sein. Hierbei wird von der Auswerteeinheit 4 das Differenzsignal der beiden Detektoren 1 und 2 ermittelt und bei Erreichen eines Schwellwerts des Differenzsignals das Ausgangssignal geändert, bei Unterschreiten eines zweiten, von dem ersten Schwellwert verschiedenen (und typischerweise im Hinblick auf die elektrische Spannung tieferen) Schwellwerts das Ausgangssignal wieder in den ursprünglichen Zustand geführt.

Eine seitliche Ansicht eines Wippschalters 8 ist in Figur 6 dargestellt. Der Wippschalter 8 kann durch seine mittige Lagerung um die Lagerung gedreht werden. In einem Fuß des Wippschalters 8,der aus Plastik ist, in weiteren Ausführungsbeispielen aber auch aus Metall sein kann, ist der Magnet 3 angeordnet, der von mehreren Detektoren 1, 2 umgeben ist. Bei einer Betätigung des Wippschalters 8 ändert sich die Lage des Magneten 3 hinsichtlich der Detektoren 1, 2 und dementsprechend ein Magnetfluss, so dass aus den Detektorsignalen auf die Position des Wippschalters 8 geschlossen werden kann.

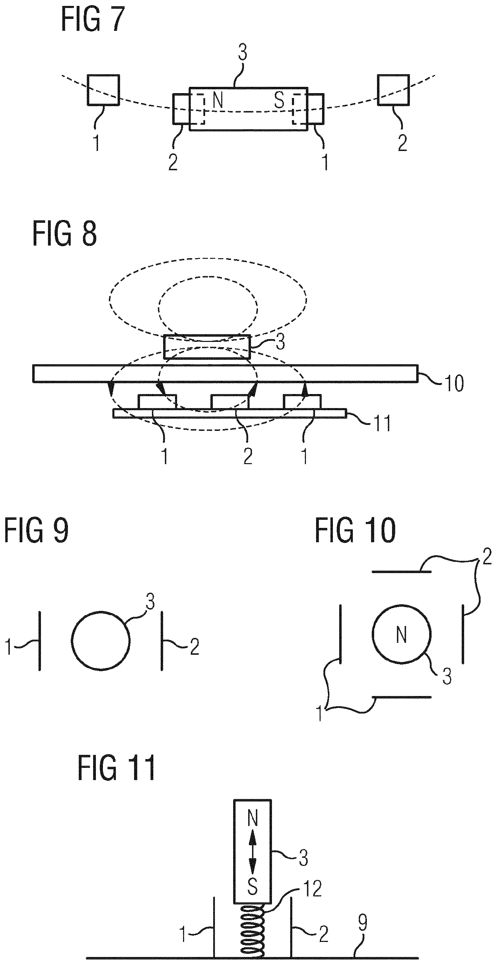

Figur 7 zeigt eine ebenfalls für den Wippschalter 8 verwendbare Anordnung des Magneten 3 und der Detektoren 1, 2 dar, bei der die Detektoren 1, 2 auf einem Kreisbogen angeordnet sind, entlang dem der Magnet 3 bewegbar ist.

In Figur 8 ist in einer seitlichen Ansicht ein nicht zur Erfindung gehörendes Beispiel gezeigt, bei dem zwischen dem Magneten 3 und den Detektoren 1, 2, die auf einer Halterung 11 angeordnet sind, eine Metallplate 10 eines Gehäuses als trennendes Bauteil angeordnet ist. Der Magnet 3 wird oberhalb der Metallplatte 10 bewegt, während die Detektoren 1, 2 unterhalb dieser Platte angeordnet sind.

In Figur 9 ist in einer Draufsicht das erfindungsgemäße Sensorelement mit dem Magneten 3 und neben dem Magneten 3 angeordneten, einander gegenüberliegenden Detektoren 1 und 2 dargestellt. Die Draufsicht entspricht der in Figur 11 in einer seitlichen Ansicht gezeigten Anordnung. Figur 10 zeigt in einer Figur 9 entsprechenden Ansicht ein Ausführungsbeispiel, bei die Detektoren 1, 2 wiederum redundant um den Magneten 3 angeordnet sind, so dass die Zuverlässigkeit der Anordnung durch redundante Auswertung erhöht wird.

In Figur 11 ist in einer seitlichen Ansicht ein Ausführungsbeispiel dargestellt, bei dem auf einer Platte 9 die Detektoren 1, 2 angeordnet sind sowie zwischen den Detektoren 1, 2 ein Federelement 12, an dessen der Platte 9 gegenüberliegenden Ende sich der Magnet 3 befindet. Durch das Federelement 12 ist der Magnet 3 federnd gelagert und kann auf und nieder bewegt werden, so dass die Detektoren 1, 2 die lokale Änderung des Magnetfelds bzw. des magnetischen Flusses detektieren.

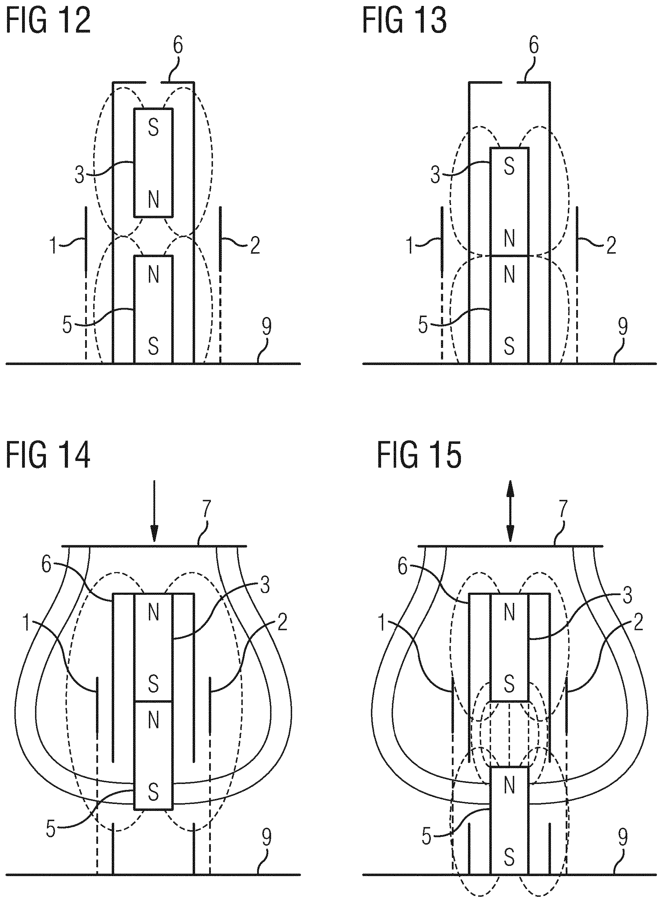

Figur 12 zeigt in einer schematischen seitlichen Ansicht ein Ausführungsbeispiel, bei dem auf der Platte 9 ein Führungselement 6 angeordnet ist. In dem Führungselement 6 sind der erste Magnet 3 und ein zweiter Magnet 5 derart angeordnet, dass ihre Längsachsen parallel zueinander verlaufen bzw. übereinstimmen. In dem in Figur 12 dargestellten Ausführungsbeispiel bilden also der erste Magnet 3 und der zweite Magnet 5 die Magnetanordnung. Der zweite Magnet 5 befindet sich auf dem Boden der Platte und die beiden Nordpole der Magneten 3, 5 sind einander zugewandt. Der entsprechende Feldlinienverlauf, der an den in der Mitte des Führungselements 6 angebrachten Detektoren 1, 2 vorliegt, ist ebenfalls eingezeichnet.

In Figur 13 sind die beiden Magneten 3, 5 nun durch eine externe Kraft aneinandergedrückt, so dass sich der Feldlinienverlauf ändert und durch die Detektoren 1, 2 nachweisbar ist.

Figur 14 zeigt ebenfalls in einer seitlichen Ansicht ein Betätigungselement 7, an dem der Magnet 5 befestigt ist. Wie in den Figuren 12 und 13 sind die Magneten 3 und 5 in dem Führungselement 6 geführt, nun jedoch derart angeordnet, dass der Nordpol des Magneten 5 dem Südpol des Magneten 3 zugewandt ist. Der Magnet 3 ist hierbei mechanisch an einem oberen Ende des Führungselements 6 fixiert. Die Detektoren 1 und 2 sind wie in den Figuren 12 und 13 mittig an dem Führungselement 6 angeordnet, jedoch wiederum von diesem beabstandet. Wie in Figur 14 dargestellt bilden die Magneten 3 und 5 im aneinandergefügten Zustand eine Feldlinienverteilung aus, die dem eines einzelnen Magneten entspricht, der gerade eine Länge aufweist, die der Summe der Längen der Magnete 3 und 5 entspricht. Bei dem in Figur 15 gezeigten getrennten Zustand der Magnete 3 und 5 bildet sich hingegen bedingt durch einen Spalt zwischen den beiden Magneten ein anderer Feldlinienverlauf aus. Die Änderung in der Feldlinienverteilung wird wiederum durch die Detektoren 1 und 2 registriert.

Figur 15 zeigt nun einen Zustand der in Figur 14 vorgestellten Anordnung, bei der nach Betätigen des Betätigungselements 7 der zweite Magnet 5 von dem ersten Magneten 3 getrennt wurde und die auf der Platte 9 angeordneten Detektoren 1, 2 den veränderten Feldlinienverlauf messen können.

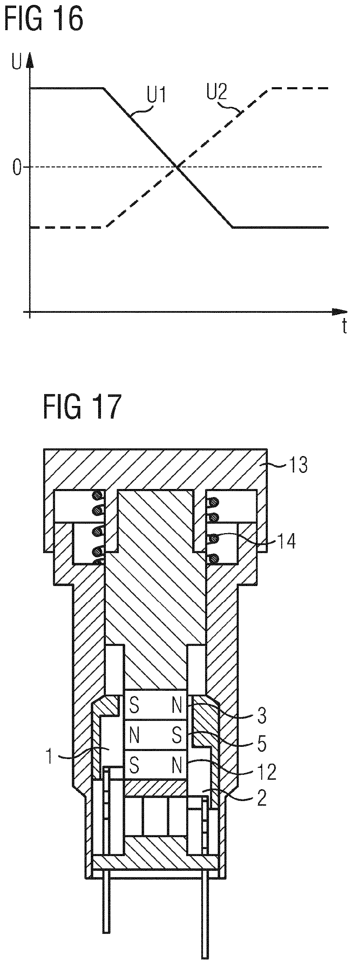

In Figur 16 ist ein zeitlicher Verlauf von an den beiden Detektoren 1 und 2 gemessenen elektrischen Signalen dargestellt. In dem gezeigten Ausführungsbeispiel sind die elektrischen Signale elektrische Spannungen, beispielsweise Hallspannungen, in weiteren Ausführungsbeispielen kann aber auch ein elektrischer Strom verwendet werden. Bei dem in Figur 16 dargestellten Ausführungsbeispiel werden in ihrer Polarität unterschiedliche elektrische Spannungen bedingt durch entgegengesetzt gerichtete Anteile des Magnetflusses an den beiden Detektoren generiert. Wird die Magnetanordnung von einer ersten Endlage in eine zweite Endlage bewegt, ändert sich die jeweilige elektrische Spannung. Sobald beide Spannungswerte gleich sind, im dargestellten Ausführungsbeispiel also bei einem Nulldurchgang, wird ein Schaltsignal durch die nachgeschaltete Auswerteeinheit 4 generiert. Bei Vorliegen von Hystereseeffekten kann natürlich bei einer entgegengesetzten Bewegung auch ein zweiter Schaltpunkt vorgesehen sein.

Figur 17 zeigt in einer Schnittdarstellung einen Schalter, bei dem ein erster Magnet 3, ein zweiter Magnet 5 und ein dritter Magnet 12 die Magnetanordnung bilden und mit ihren Längsachsen parallel zueinander übereinander angeordnet sind. Diese Magnetanordnung kann in einer linearen Bewegung zwischen dem ersten Detektor 1 und dem zweiten Detektor 2 bewegt werden. Die beiden Detektoren 1 und 2 sind nun nicht mehr fluchtend einander gegenüberliegend angeordnet, sondern räumlich versetzt zueinander, wobei einer der Detektoren 1, 2 oberhalb des anderen platziert ist. Die sensitiven Oberflächen 1 und 2 der Detektoren sind parallel ausgerichtet in Richtung der Magnetanordnung orientiert. Die Magnetanordnung und die Detektoranordnung sind derart zueinander angeordnet, dass gerade eine der Komponenten des Magnetfelds Bₓ, B_{y}, B_{z}, bzw. magnetischen Flusses in der ersten Endlage und der zweiten Endlage von den Detektoren detektiert wird und in diesen Endlagen ein unterschiedliches Vorzeichen aufweist. Ein Betrag dieser detektierten Komponente beträgt typischerweise bis zu 40 mT.

Die Magnetanordnung ist an einem über eine Feder 14 betätigbaren Schalter 13 bzw. Taster angeordnet. Bei Betätigung des Schalters 13 wird beispielsweise der in Figur 16 gezeigte Spannungsverlauf realisiert, so dass ein Schaltpunkt bestimmt werden kann.

## Patentansprüche

1. Schalter mit
einer Magnetanordnung mit mindestens einem ersten Magneten (3) und
einem ersten Magnetfelddetektor (1), der ein erstes elektrisches Signal ausgibt, und einem zweiten Magnetfelddetektor (2), der ein zweites elektrisches Signal ausgibt, wobei der erste Magnetfelddetektor (1) und der zweite Magnetfelddetektor (2) einen räumlichen Abstand zueinander aufweisen und beidseitig neben dem Magneten (3) angeordnet sind, und einer elektrischen oder elektronischen Auswerteeinheit wobei
sensitive Oberflächen des ersten Magnetfelddetektors (1) und des zweiten Magnetfelddetektors (2) parallel zueinander ausgerichtet sind und
die Magnetanordnung zwischen dem ersten Magnetfelddetektor (1) und dem zweiten Magnetfelddetektor (2) in einer Relativbewegung parallel zu den sensitiven Oberflächen bewegbar angeordnet ist, wobei ein von dem ersten Magnetfelddetektor (1) und ein von dem zweiten Magnetfelddetektor (2) detektierter Vektor des Magnetfelds in einer ersten Endlage der Relativbewegung und in einer zweiten Endlage der Relativbewegung in nur einer detektierten Komponente des Vektors des Magnetfelds ein unterschiedliches Vorzeichen aufweist und die elektrische oder elektronische Auswerteeinheit (4) dem ersten
Magnetfelddetektor (1) und dem zweiten Magnetfelddetektor (2) nachgeschaltet und dazu eingerichtet ist, eine Differenz des ersten
elektrischen Signals und des zweiten elektrischen Signals zu ermitteln und bei Erreichen eines festgelegten ersten Werts der Differenz bei der Relativbewegung von der ersten Endlage in die zweite Endlage der Relativbewegung ein erstes Schaltsignal und bei Erreichen eines festgelegten zweiten Werts der Differenz bei der Relativbewegung von der zweiten Endlage in die erste Endlage der Relativbewegung ein zweites Schaltsignal auszugeben.

2. Schalter nach Anspruch 1, **dadurch gekennzeichnet, dass** das erste elektrische Signal und das zweite elektrische Signal sich in ihrer Polarität unterscheiden und/oder der festgelegte erste Wert und der festgelegte zweite Wert der Differenz identisch und vorzugsweise null sind.

3. Schalter nach einem der vorhergehenden Ansprüche, **dadurch gekennzeichnet, dass** die Relativbewegung innerhalb des mit dem ersten Magnetfelddetektor (1) und mit dem zweiten Magnetfelddetektor (2) detektierbaren Magnetfelds der Magnetanordnung erfolgt.

4. Schalter nach einem der vorhergehenden Ansprüche, **dadurch gekennzeichnet, dass** ein Abstand zwischen dem mindestens einen Magneten (3) und dem ersten Magnetfelddetektor (1), ein Abstand zwischen dem mindestens einen Magneten (3) und dem zweiten Magnetfelddetektor (1) und/oder ein Abstand zwischen dem ersten Magnetfelddetektor (1) und dem zweiten Magnetfelddetektor (2) kleiner als eine maximale Ausdehnung des jeweiligen Magneten (3) ist/sind.

5. Schalter nach einem der vorhergehenden Ansprüche, **dadurch gekennzeichnet, dass** ein Abstand zwischen einer Oberfläche der Magnetanordnung und einer sensitiven Oberfläche des ersten Magnetfelddetektors (1) oder des zweiten Magnetfelddetektors (2) maximal 1,5 mm beträgt.

6. Schalter nach einem der vorhergehenden Ansprüche, **dadurch gekennzeichnet, dass** die in ihrem Vorzeichen unterschiedliche Komponente, die am ersten Magnetfelddetektor (1) detektiert wird, betragsmäßig gleich der entsprechenden Komponente ist, die am zweiten Magnetfelddetektor (2) detektiert wird und/oderder erste Magnetfelddetektor (1) und/oder der zweite Magnetfelddetektor (2) als ein Magnetowiderstandseffektsensor, ein Hall-Effektsensor und/oder ein Riesenmagnetowiderstandseffektsensor ausgebildet ist.

7. Schalter nach einem der vorhergehenden Ansprüche, **dadurch gekennzeichnet, dass** der erste Magnetfelddetektor (1) und der zweite Magnetfelddetektor (2) derart angeordnet sind, dass Flusslinien des von der Magnetanordnung generierten Magnetfelds die Magnetfelddetektoren (1, 2) in unterschiedlichen Richtungen durchqueren.

8. Schalter nach einem der vorhergehenden Ansprüche, **dadurch gekennzeichnet, dass** der erste Magnetfelddetektor (1) und der zweite Magnetfelddetektor (2) derart angeordnet sind, dass in ihrer Flussrichtung durch den jeweiligen Detektor (1, 2) gegenläufige Anteile des Magnetflusses detektiert werden.

9. Schalter nach einem der vorhergehenden Ansprüche, **dadurch gekennzeichnet, dass** der erste Magnetfelddetektor (1) und der zweite Magnetfelddetektor (2) mit ihren sensitiven Oberflächen fluchtend einander gegenüberliegend angeordnet sind.

10. Schalter nach einem der vorhergehenden Ansprüche, **dadurch gekennzeichnet, dass** die Magnetanordnung einen ersten Magneten (3) und einen zweiten (5) Magneten aufweist, wobei die Längsachsen des ersten Magneten (3) und des zweiten Magneten (5) parallel zueinander angeordnet sind.

11. Schalter nach Anspruch 10, **dadurch gekennzeichnet, dass** der erste Magnet (3) und der zweite Magnet (5) mit ihren Längsachsen parallel zueinander angeordnet sind, wobei ein Nordpol des ersten Magneten (3) einem Südpol des zweiten Magneten (5) benachbart ist.

12. Schalter nach Anspruch 10 oder 11, **dadurch gekennzeichnet**, das die Magnetanordnung den ersten Magneten (3), den zweiten Magneten (5) und einen dritten Magneten (12) aufweist, wobei der dritte Magnet (12) mit seiner Längsachse parallel zu den Längsachsen des ersten Magneten (3) und des zweiten Magneten (5) angeordnet ist und ein Nordpol des dritten Magneten (12) einem Südpol des zweiten Magneten (5) zugewandt angeordnet ist.

13. Schalter nach einem der Ansprüche 10 bis 12, **dadurch gekennzeichnet, dass** der erste Magnetfelddetektor (1) und der zweite Magnetfelddetektor (2) mit ihren sensitiven Oberflächen versetzt zueinander angeordnet sind.

14. Schalter nach einem der vorhergehenden Ansprüche, **dadurch gekennzeichnet, dass** die Magnetanordnung oder der erste Magnetfelddetektor (1) und der zweite Magnetfelddetektor (2) an einem mechanisch betätigbaren und als Folge der Betätigung beweglichen Betätigungselement (13) angeordnet sind.

15. Schalter nach einem der vorhergehenden Ansprüche, **dadurch gekennzeichnet, dass** die Magnetanordnung und der erste Magnetfelddetektor (1) oder die Magnetanordnung und der zweite Magnetfelddetektor (2) durch mindestens ein weiteres Bauteil räumlich voneinander getrennt sind.

## Claims

1. A switch comprising:
a magnet assembly comprising at least one first magnet (3);
and
a first magnetic field detector (1), which outputs a first electrical signal, and a second magnetic field detector (2), which outputs a second electrical signal, the first magnetic field detector (1) and the second magnetic field detector (2) being arranged at a spatial distance with respect to one another and being arranged on both sides next to the magnet (3), and an electric or electronic evaluation unit (4),
sensitive surfaces of the first magnetic field detector (1) and of the second magnetic field detector (2) being oriented parallel to one another, and
the magnet assembly being arranged movably between the first magnetic field detector (1) and the second magnetic field detector (2) in a relative movement parallel to the sensitive surfaces,
a vector of the magnetic field detected by the first magnetic field detector (1) and a vector detected by the second magnetic field detector (2), in a first final position of the relative movement and in a second final position of the relative movement, having different signs only in one detected component of the vector of the magnetic field, and
the electric or electronic evaluation unit (4) being connected downstream of the first magnetic field detector (1) and the second magnetic field detector (2) and configured to ascertain a difference between the first electrical signal and the second electrical signal, and to output a first switch signal when an established first value of the difference is reached during the relative movement from the first final position into the second final position of the relative movement, and to output a second switch signal when an established second value of the difference is reached during the relative movement from the second final position into the first final position of the relative movement.

2. The switch according to claim 1, **characterized in that** the first electrical signal and the second electrical signal differ in terms of the polarities thereof, and/or the established first value and the established second value of the difference are identical and preferably zero.

3. A switch according to any one of the preceding claims, **characterized in that** the relative movement is carried out within the magnetic field of the magnet assembly detectable by way of the first magnetic field detector (1) and by way of the second magnetic field detector (2).

4. A switch according to any one of the preceding claims, **characterized in that** a distance between the at least one magnet (3) and the first magnetic field detector (1), a distance between the at least one magnet (3) and the second magnetic field detector (1) and/or a distance between the first magnetic field detector (1) and the second magnetic field detector (2) is/are smaller than a maximum extension of the respective magnet (3).

5. A switch according to any one of the preceding claims, **characterized in that** a distance between a surface of the magnet assembly and a sensitive surface of the first magnetic field detector (1) or of the second magnetic field detector (2) is no more than 1.5 mm.

6. A switch according to any one of the preceding claims, **characterized in that** the component having a different sign which is detected at the first magnetic field detector (1) is identical, in absolute terms, to the corresponding component which is detected at the second magnetic field detector (2) and/or the first magnetic field detector (1) and/or the second magnetic field detector (2) are designed as magnetoresistive effect sensors, Hall effect sensors and/or giant magnetoresistive effect sensors.

7. A switch according to any one of the preceding claims, **characterized in that** the first magnetic field detector (1) and the second magnetic field detector (2) are arranged in such a way that flux lines of the magnetic field generated by the magnet assembly traverse the magnetic field detectors (1, 2) in different directions.

8. A switch according to any one of the preceding claims, **characterized in that** the first magnetic field detector (1) and the second magnetic field detector (2) are arranged in such a way that fractions of the magnetic flux having opposite flux directions through the respective detector (1, 2) are detected.

9. A switch according to any one of the preceding claims, **characterized in that** the first magnetic field detector (1) and the second magnetic field detector (2) are arranged, with the sensitive surfaces thereof, aligned and opposite one another.

10. A switch according to any one of the preceding claims, **characterized in that** the magnet assembly comprises a first magnet (3) and a second magnet (5), the longitudinal axes of the first magnet (3) and of the second magnet (5) being arranged parallel to one another.

11. The switch according to claim 10, **characterized in that** the first magnet (3) and the second magnet (5) are arranged, with the longitudinal axes thereof, parallel to one another, a magnetic north of the first magnet (3) adjoining a magnetic south of the second magnet (5).

12. The switch according to claim 10 or 11, **characterized in that** the magnet assembly comprises the first magnet (3), the second magnet (5) and a third magnet (12), the third magnet (12) being arranged, with the longitudinal axis thereof, parallel to the longitudinal axes of the first magnet (3) and of the second magnet (5), and a magnetic north of the third magnet (12) being arranged so as to face a magnetic south of the second magnet (5).

13. A switch according to any one of claims 10 to 12, **characterized in that** the first magnetic field detector (1) and the second magnetic field detector (2) are arranged, with the sensitive surfaces thereof, offset from one another.

14. A switch according to any one of the preceding claims, **characterized in that** the magnet assembly or the first magnetic field detector (1) and the second magnetic field detector (2) are arranged at an actuating element (13) that can be mechanically actuated and moved as a result of the actuation.

15. A switch according to any one of the preceding claims, **characterized in that** the magnet assembly and the first magnetic field detector (1), or the magnet assembly and the second magnetic field detector (2), are spatially separated from one another by at least one further component.

## Revendications

1. Commutateur avec
un ensemble d'aimants avec au moins un premier aimant (3) et un premier détecteur de champ magnétique (1), qui émet un premier signal électrique, et un deuxième détecteur de champ magnétique (2), qui émet un deuxième signal électrique, dans lequel le premier détecteur de champ magnétique (1) et le deuxième détecteur de champ magnétique (2) présentent une distance spatiale l'un par rapport à l'autre et sont disposés de part et d'autre à côté de l'aimant (3), et une unité d'évaluation électrique ou électronique (4), dans lequel
les surfaces sensibles du premier détecteur de champ magnétique (1) et du deuxième détecteur de champ magnétique (2) sont orientées parallèlement l'une à l'autre et
l'ensemble d'aimants est disposé de manière à pouvoir se déplacer entre le premier détecteur de champ magnétique (1) et le deuxième détecteur de champ magnétique (2) dans un mouvement relatif parallèle aux surfaces sensibles, dans lequel
un vecteur du champ magnétique détecté par le premier détecteur de champ magnétique (1) et un vecteur du champ magnétique détecté par le deuxième détecteur de champ magnétique (2) présentent dans une première position finale du mouvement relatif et dans une deuxième position finale du mouvement relatif un signe différent dans une seule composante détectée du vecteur du champ magnétique et
l'unité d'évaluation électrique ou électronique (4) est connectée en aval du premier détecteur de champ magnétique (1) et du deuxième détecteur de champ magnétique (2) et est configurée pour déterminer une différence entre le premier signal électrique et le deuxième signal électrique et lorsqu'une première valeur fixée de la différence lors du mouvement relatif de la première position finale vers la deuxième position finale du mouvement relatif est atteinte, pour émettre un premier signal de commutation, et lorsqu'une deuxième valeur fixée de la différence lors du mouvement relatif de la deuxième position finale vers la première position finale du mouvement relatif est atteinte, pour émettre un deuxième signal de commutation.

2. Commutateur selon la revendication 1, **caractérisé en ce que** le premier signal électrique et le deuxième signal électrique se différencient par leur polarité et/ou la première valeur fixée et la deuxième valeur fixée de la différence sont identiques et de préférence nulles.

3. Commutateur selon l'une quelconque des revendications précédentes, **caractérisé en ce que** le mouvement relatif s'effectue à l'intérieur du champ magnétique de l'ensemble d'aimants pouvant être détecté avec le premier détecteur de champ magnétique (1) et avec le deuxième détecteur de champ magnétique (2).

4. Commutateur selon l'une quelconque des revendications précédentes, **caractérisé en ce qu'**une distance entre l'au moins un aimant (3) et le premier détecteur de champ magnétique (1), une distance entre l'au moins un aimant (3) et le deuxième détecteur de champ magnétique (1) et/ou une distance entre le premier détecteur de champ magnétique (1) et le deuxième détecteur de champ magnétique (2) est/sont inférieure(s) à une étendue maximale de l'aimant (3) respectif.

5. Commutateur selon l'une quelconque des revendications précédentes, **caractérisé en ce qu'**une distance entre une surface de l'ensemble d'aimants et une surface sensible du premier détecteur de champ magnétique (1) ou du deuxième détecteur de champ magnétique (2) atteint au maximum 1,5 mm.

6. Commutateur selon l'une quelconque des revendications précédentes, **caractérisé en ce que** la composante différente par son signe, qui est détectée sur le premier détecteur de champ magnétique (1), est égale en grandeur à la composante correspondante qui est détectée sur le deuxième détecteur de champ magnétique (2) et/ou le premier détecteur de champ magnétique (1) et/ou le deuxième détecteur de champ magnétique (2) est réalisé sous la forme d'un capteur à effet de magnétorésistance, d'un capteur à effet Hall et/ou d'un capteur à effet de magnétorésistance géante.

7. Commutateur selon l'une quelconque des revendications précédentes, **caractérisé en ce que** le premier détecteur de champ magnétique (1) et le deuxième détecteur de champ magnétique (2) sont disposés de telle sorte que les lignes de flux du champ magnétique généré par l'ensemble d'aimants traversent les détecteurs de champ magnétique (1, 2) dans différentes directions.

8. Commutateur selon l'une quelconque des revendications précédentes, **caractérisé en ce que** le premier détecteur de champ magnétique (1) et le deuxième détecteur de champ magnétique (2) sont disposés de telle sorte que des parts opposées du flux magnétique sont détectées dans leur direction de flux à travers le détecteur (1, 2) respectif.

9. Commutateur selon l'une quelconque des revendications précédentes, **caractérisé en ce que** le premier détecteur de champ magnétique (1) et le deuxième détecteur de champ magnétique (2) sont disposés avec leurs surfaces sensibles alignées l'une en face de l'autre.

10. Commutateur selon l'une quelconque des revendications précédentes, **caractérisé en ce que** l'ensemble d'aimants comprend un premier aimant (3) et un deuxième (5) aimant, dans lequel les axes longitudinaux du premier aimant (3) et du deuxième aimant (5) sont disposés parallèlement l'un à l'autre.

11. Commutateur selon la revendication 10, **caractérisé en ce que** le premier aimant (3) et le deuxième aimant (5) sont disposés parallèlement l'un à l'autre avec leurs axes longitudinaux, dans lequel un pôle Nord du premier aimant (3) est voisin d'un pôle Sud du deuxième aimant (5).

12. Commutateur selon la revendication 10 ou 11, **caractérisé en ce que** l'ensemble d'aimants comprend le premier aimant (3), le deuxième aimant (5) et un troisième aimant (12), dans lequel le troisième aimant (12) est disposé avec son axe longitudinal parallèlement aux axes longitudinaux du premier aimant (3) et du deuxième aimant (5) et un pôle Nord du troisième aimant (12) est disposé de manière tournée vers un pôle Sud du deuxième aimant (5).

13. Commutateur selon l'une quelconque des revendications 10 à 12, **caractérisé en ce que** le premier détecteur de champ magnétique (1) et le deuxième détecteur de champ magnétique (2) sont disposés avec leurs surfaces sensibles décalées l'un par rapport à l'autre.

14. Commutateur selon l'une quelconque des revendications précédentes, **caractérisé en ce que** l'ensemble d'aimants ou le premier détecteur de champ magnétique (1) et le deuxième détecteur de champ magnétique (2) sont disposés sur un élément d'actionnement (13) pouvant être actionné mécaniquement et pouvant être déplacé à la suite de l'actionnement.

15. Commutateur selon l'une quelconque des revendications précédentes, **caractérisé en ce que** l'ensemble d'aimants et le premier détecteur de champ magnétique (1) ou l'ensemble d'aimants et le deuxième détecteur de champ magnétique (2) sont séparés l'un de l'autre dans l'espace par au moins une autre pièce.
